# EUROPEAN PATENT APPLICATION

(11) **EP 1 787 947 A2**
(43) Date of publication of application: **23.05.2007**
(21) Application number: 06124143.6
(22) Date of filing: 15.11.2006
(51) Int. Cl.: B81B 7/00

(54) **Mems Flip-Chip Packaging**

(30) Priority: 22.11.2005 US 164451
(71) Applicant: Honeywell International Inc., Morristown, NJ 07962 (US)
(72) Inventor: DCamp, Jon B., Savage, MN 55378 (US)
(74) Representative: Haley, Stephen

(57) **Abstract**

Packaging of MEMS and other devices, and in some cases, devices that have vertically extending structures. Robust packaging solutions for such devices are provided, which may result in superior vacuum performance and/or increased protection in some environments such as high-G environments, while also providing high volume throughput and low cost during the fabrication process.

## Description

The present invention relates generally to the field of semiconductor manufacturing and Micro Electro Mechanical Systems (MEMS). More specifically, the present invention relates to methods for packaging of MEMS and other devices, and in some cases, devices that have vertically extending structures thereon.

Microelectromechanical system (MEMS) devices often employ semiconductor fabrication techniques to create small mechanical structures on the surface of a substrate such as a wafer. In the production of MEMS gyroscopes and accelerometers, for example, such fabrication techniques are often used to create a number of moving structures that can be used to sense displacement and/or acceleration in response to movement of the device about an input or rate axis. In navigational and communications systems, for example, such moving structures can be used to measure and/or detect variations in linear and/or rotational motion of an object traveling through space. In other applications, such as automotive systems, for example, such moving structures can be used in vehicle dynamic control (VDC) systems and antilock braking system (ABS) to sense changes in vehicle and/or tire motion.

The packaging of such MEMS devices remains a significant hurdle in the overall fabrication process. In many cases, MEMS die include a MEMS side and a back side. The back side of the MEMS die is often bonded to the floor of a cavity in a MEMS package. Wire bond pads on the MEMS side of the MEMS die are typically wire bonded to bond pads in or along the MEMS package cavity. Finally, a package lid is typically secured to the top of the MEMS package to provide a hermitic seal for the MEMS package cavity. In some cases, the lid is secured in a vacuum or partial vacuum to provide a desired environment for the enclosed MEMS device. When a partial vacuum is used, and in some embodiments, an inert gas may be introduced when the lid is secured to the top of the MEMS package so that an inert gas is back filled into the enclosure housing the MEMS device, but this is not required.

Due to their size and composition, the mechanical structures of many MEMS devices are susceptible to damage in high-G applications, and from particles, moisture or other such contaminants that can become entrained within the MEMS package cavity. In addition, and in some cases, the difficulty in accurately regulating the pressure within the MEMS package cavity during the fabrication process can affect the performance characteristics of the MEMS device, often reducing its efficacy in detecting subtle changes in motion. Furthermore, some MEMS devices have vertically extending structures that extend up from the MEMS die, which in some cases, may present a challenge for flip-chip die bonding. As such, there is a need for robust packaging solutions for MEMS devices that offer superior vacuum performance and/or increased protection in some environments such as high-G environments, while also providing high volume throughput and low cost during the fabrication process.

### Summary

The present invention relates to the packaging of MEMS and other devices, and in some cases, devices that have vertically extending structures thereon. The present invention may provide robust packaging solutions for such devices, which may result in superior vacuum performance and/or increased protection in some environments such as high-G environments, while also providing high volume throughput and low cost during the fabrication process.

In one illustrative embodiment, a MEMS die is provided that includes a MEMS device secured to a substrate. The MEMS device may include one or more suspended structures positioned vertically above the substrate. The suspended structures may be located in a first region of the substrate, and a second region may extend around the periphery of the first region of the substrate. In some cases, a seal ring is disposed on the second portion of the substrate, wherein the seal ring extends around the first portion of the substrate. A plurality of bond pads may be positioned along the second portion of the substrate. The plurality of bond pads may be positioned inside of the seal ring (e.g. between the seal ring and the one or more suspended structures) and/or outside of the seal ring, as desired.

Such a MEMS device may be packaged in a corresponding MEMS package. The MEMS package may have a package body that has a recess in a surface thereof to form a cavity. The cavity may be adapted to receive the one or more suspended structures of the MEMS device. A seal ring may be situated on the package body, which encircles the recess. The seal ring may be adapted to be in registration with the seal ring of the MEMS die when the MEMS die and MEMS package are brought together. A plurality of bond pads may be disposed on the surface of the package body, wherein one or more of the bond pads are in registration with one or more of the bond pads of the MEMS die.

The MEMS die may be flipped over and so that the one or more suspended structures of the MEMS device extend at least partially into the cavity of the MEMS package. The seal ring of the MEMS die may then be aligned with the seal ring of the MEMS package. In some cases, a solder pre-form may be placed between the seal ring of the MEMS die and the seal ring of the MEMS package, which when heated, may form a hermitic seal between the substrate of the MEMS die and the MEMS package. In other cases, a sufficient quantity of bonding material such as gold or aluminum may be provided along the seal ring, and the MEMS die and the MEMS package may be sealed together along the seal ring using thermo-compression bonding. In yet other cases, the MEMS die and the MEMS package may be sealed together along the seal ring using resistance welding, eutectic bonding, or using any other suitable bonding approach.

In some cases, the MEMS die and MEMS package may be sealed together in a low pressure environment, such as a vacuum environment. This may result in a sealed low pressure environment in the cavity, which for some MEMS devices, may be desirable.

One or more of the bond pads of the MEMS die may be bonded to one or more bond pads of the MEMS package. In some cases, the one or more bond pads of the MEMS die are bonded to one or more bond pads of the MEMS package at the same time as the MEMS die and the MEMS package are sealed together along their seal rings. The one or more bond pads of the MEMS die may be bonded to the one or more bond pads of the MEMS package using any suitable bonding approach. For example, the one or more bond pads of the MEMS die may be bonded to the one or more bond pads of the MEMS package by, for example, soldering, eutectic bonding, thermo-compression bonding, resistance welding, adhesives, or by any other suitable attachment process.

Also, it is contemplated that the seal rings of the MEMS die and the MEMS package may be secured by one attachment process, and the bond pads may be secured with the same or different attachment process, as desired. For example, the seal rings may be secured by soldering, and the bond pads may be secured by thermo-compression bonding, or visa versa. When the seal rings are secured by soldering, the seal rings may be made from a material or material system that allows solder to wet to the MEMS die and MEMS package. As noted above, and in some cases, a solder pre-form is provided and placed between the seal rings of the MEMS die and the MEMS package to help form the seal between the seal rings.

In some cases, the MEMS package may be picked and placed into a bonding chamber. The MEMS package may be photo-registered (e.g. using pattern recognition) for placement accuracy. The MEMS die may in some cases be placed into a flipper station that flips the MEMS die so that the MEMS side of the MEMS die faces down toward the MEMS package. The MEMS die may then be picked by a tool head and photo-registered (e.g. using pattern recognition) for placement accuracy. The tool head may move the MEMS die into position over the MEMS package. The bonding chamber may be evacuated to approximately 10x10⁻⁵ torr, as desired. Heat may be applied to the MEMS die and/or MEMS package, sometimes via the tool head, which may melt the solder pre-form and/or prepare the MEMS package for thermo-compression bonding with the MEMS die. The tool head may also apply force to the MEMS die to help form the bond, creating a hermitically sealed cavity with the MEMS device therein and electrically connected the bond pads to the MEMS package bond pads. The cavity may then be cooled and vented.

### In the Drawings;

Figure 1 is a schematic cross-sectional side view of an illustrative MEMS die, solder pre-form and MEMS package;

Figure 2 is schematic top view of the MEMS die, solder pre-form and MEMS package of Figure 1;

Figure 3 is a schematic cross-sectional side view of the illustrative MEMS die, solder pre-form and MEMS package of Figures 1-2 after assembly;

Figure 4 is a schematic cross-sectional side view of another illustrative MEMS die, solder pre-form and MEMS package;

Figure 5 is a schematic cross-sectional side view of the illustrative MEMS die, solder pre-form and MEMS package of Figure 4 after assembly; and

Figure 6 is a schematic cross-sectional side view showing an illustrative method for making a MEMS die having an upper sense plate.

The following description should be read with reference to the drawings, in which like elements in different drawings are numbered in like fashion. The drawings, which are not necessarily to scale, depict selected embodiments and are not intended to limit the scope of the invention. Although examples of construction, dimensions, and materials are illustrated for the various elements, those skilled in the art will recognize that many of the examples provided have suitable alternatives that may be utilized. While the fabrication of MEMS inertial sensors such as MEMS gyroscopes and MEMS accelerometers is specifically discussed, it should be understood that the fabrication steps and structures described herein can be utilized in the packaging of other types of MEMS devices such as electrostatic actuators, optical lenses, RF switches, relay switches, microbolometers, devices with actuatable micro-mirrors, pressure sensors and/or any other suitable device (MEMS or not), as desired.

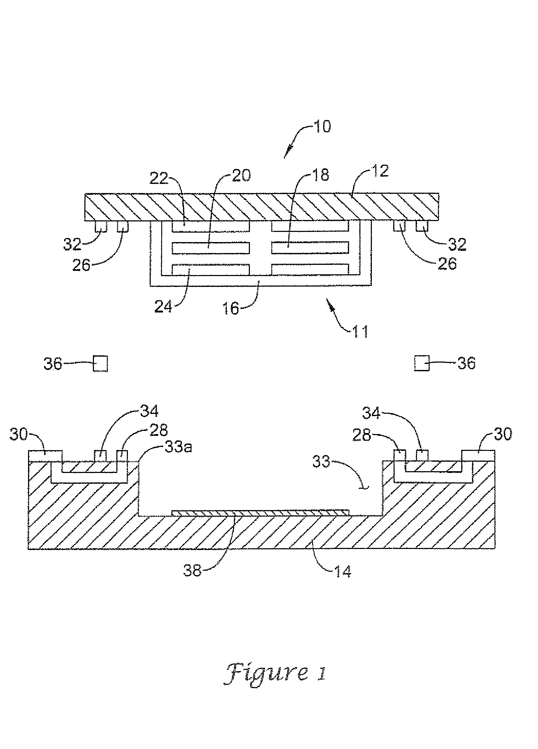

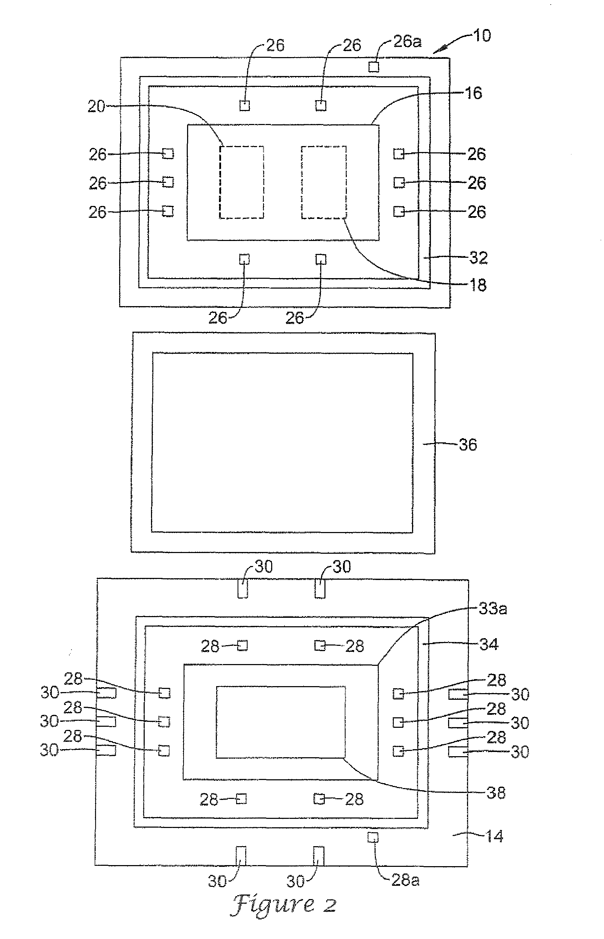

Referring now to Figure 1, an illustrative method of packaging a MEMS device will now be described. The illustrative method begins with the steps of providing a MEMS die, generally shown at 10, having a MEMS gyroscope device 11 secured to a substrate 12. The MEMS gyroscope device 11 may include one or more suspended structures positioned vertically above the substrate as shown. The suspended structures may be located in a first region 16 (see Figure 2) of the substrate 12, and a second region may extend around the periphery of the first region 16 of the substrate 12. MEMS gyroscopes are often used to sense angular displacement or movement. In many cases, MEMS gyroscopes includes two proof masses that are suspended above a substrate, and are driven electrostatically 180° out of phase along a drive plane. A lower sense plate is often provided under each of the proof masses, often directly on the substrate, to detect deflections in the positions of the proof masses caused by rotation or angular displacement of the gyroscope sensor. An upper sense plate 24 may also be provided above the proof masses to increase the sensitivity of the gyroscope, but this is not required.

In the illustrative embodiment, MEMS gyroscope 11 includes moving components 18 and 20 (e.g. proof masses), and corresponding sense plates 22 and 24. Sense plate 24 may be supported by a support structure 16. In some cases, the MEMS gyroscope 11 may be made by micromachining a silicon substrate, the result of which is bonded to a glass (e.g. Pyrex^{™}) substrate 12. In some cases, the glass substrate 12 may include one or more patterned metal layers that form, for example, lower sense plates 22 and well as I/O traces. This, however, is only illustrative, and it is contemplated that the MEMS die 10 may be made from any number of materials or material systems including, for example, quartz, silicon, gallium arsenide, germanium, glass, and/or any other suitable material. It should also be understood that other types of MEMS or other devices (*e.g.* accelerometers, electrostatic actuators, optical lenses, RF switches, relay switches, microbolometers, devices with actuatable micro-mirrors, pressure sensors, etc.) can be packaged in accordance with the present invention, as desired.

The illustrative MEMS die 10 also includes a number of bond pads 26. The bond pads 26 may be electrically connected (not illustrated) to the MEMS device 11, and in particular to one or more sense plates 22, 24, one or more proof masses 20, and/or other components or parts of the MEMS device 11, as desired. The bond pads 26 may be positioned between a patterned seal ring 32 and the MEMS device 11, but this is not required. For example, one or more bond pads 26a may be positioned outside of patterned seal ring 32 (see Figure 2).

The bond pads 26 may be connected by leads or traces running on, for example, a surface of the substrate 12, as desired. Each bond pad 26 may include a protrusion of material such as gold or lead or any material or combination of materials suitable to promote the formation of an electrical connection between the bond pad on the MEMS die 10 and the corresponding bond pad on the MEMS package 14, as further described below. The protrusion may be a solid layer or may be a plurality of bumps or concentric rings, as desired.

In some embodiments, the MEMS die 10 may also include a patterned seal ring 32. The patterned seal ring 32 may be formed by a deposition of material or other suitable technique. When a soldering process is used to bond the MEMS die 10 to the MEMS package 14 along the seal ring 32, the seal ring 32 may be made from gold, lead, tin, aluminum, platinum or other suitable materials or combination of materials suitable for providing a good wetting surface for the solder. Of course, if the sealing mechanism does not rely on solder, the patterned seal ring 32 may be made from a different material or may not be provided at all. For example, a glass frit seal may be used along the seal ring 32 to bond and seal the MEMS die 10 to the MEMS package 14, particularly if the MEMS die 10 and/or MEMS package 14 include ceramic or the like. In another example, when a thermo-compression bonding process is used to bond the MEMS die 10 to the MEMS package 14 along the seal ring 32, the seal ring 32 may include a bonding material such as gold, silver, lead, tin, aluminum, or the like, which after sufficient heat and pressure are applied, will form the desired thermo-compression bond.

The seal ring 32 may completely encircle the MEMS device 11, and in some cases, the bond pads 26. Patterned seal ring 32 may be electrically isolated from the MEMS device 11 and from the bond pads 26. The electrical isolation may be made particularly robust when, for example, resistance welding is used to bond the MEMS die 10 to the MEMS package 14 along the seal ring 32.

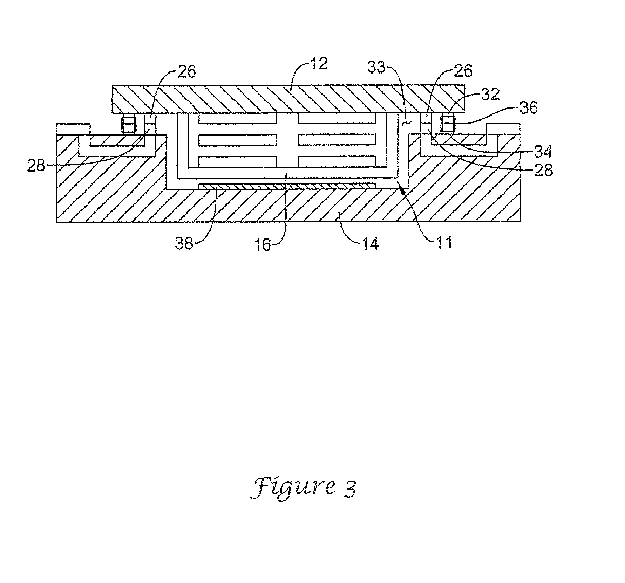

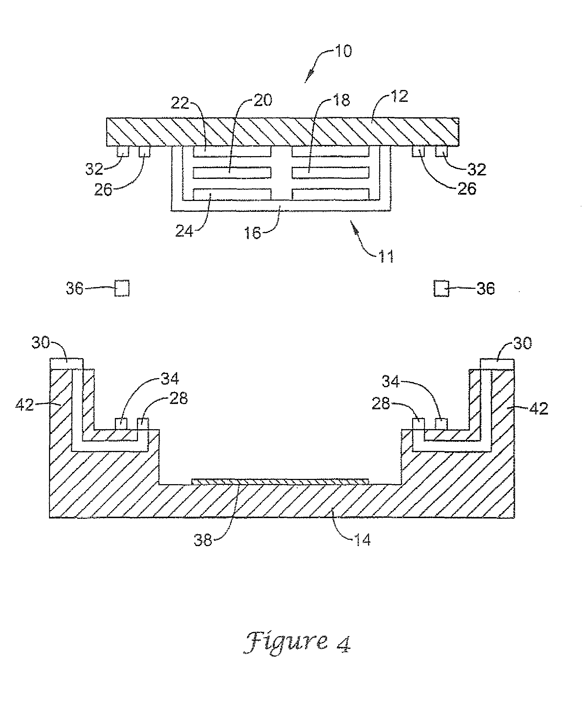

The illustrative MEMS package 14 shown in Figure 1 includes bond pads 28 and/or 28a that are configured to be in registration with or otherwise mate with bond pads 26 and/or 26a of MEMS die 10. in the illustrative embodiment, bond pads 28 and 28a are electrically connected with leads 30, which permit the MEMS package 14 to be connected to a larger circuit, such as to bond pads on a printed circuit board (not shown). As can be seen in Figure 4, the leads 30 may extend above the MEMS die 10 after final assembly so that the leads 30 can be used to mount the resulting package directly onto a printed wiring board, multi-chip package or other structure, as desired. Alternatively, and as shown in Figure 3, the leads 30 need not extend above the MEMS die 10, in which case a hole, recess or other suitable structure may be provided in the printed wiring board, multi-chip package or other structure to accommodate the MEMS die 10, or a raised ring or other structure may extend up from the printed wiring board, multi-chip package or other structure to accommodate the MEMS die 10.

MEMS package 14 may be made from any number of materials or material systems including, for example, ceramic, quartz, silicon, glass or other suitable materials. In some cases, the materials used for MEMS package 14 may be selected to help reduce or relieve mechanical stress and/or strain that may occur between the MEMS die 10 and the MEMS package 14 as the components go through various temperatures during operation and/or fabrication.

As noted above, the MEMS package 14 may include a patterned seal ring 34 that is configured to be in registration or mate with the seal ring 32 of the MEMS die 1 0. The seal ring 34 may be formed like seal ring 32 or may be formed using techniques suitable to the material of the MEMS package 14. The seal ring 34 may be electrically isolated from bond pads 28 and leads 30.

In some cases, the MEMS package 14 may include a cavity 33 with a cavity perimeter 33a, which is adapted to receive part of the MEMS die 10, such as the one or more suspended structures of MEMS device 11 (see Figure 3). A getter 38 may be provided on a surface of the cavity 33 or on another suitable surface such as structure 16 of the MEMS device 11. The getter may be deposited using sputtering, resistive evaporation, e-beam evaporation or other suitable deposition technique and may be made from zirconium, titanium, boron, cobalt, calcium, strontium, thorium, combinations thereof or other suitable getter material. The getter may be selected to chemically absorb some or all of the gases anticipated to outgas into the cavity 33, such as water vapor, oxygen, carbon monoxide, carbon dioxide, nitrogen, hydrogen, and/or other gases, as desired.

In some cases, a solder pre-form 36 may be provided. The solder pre-form 36 may be sized to correspond to patterned seal rings 32 and 34. Solder pre-form 36 may be formed of indium, lead, tin, gold, other suitable metals or suitable alloys thereof. The solder pre-form 36 may be a separate component placed on the MEMS package 14 during the assembly process. In one illustrative embodiment, solder pre-form 36 is a solder layer deposited onto MEMS package 14 or MEMS die 10 using deposition or other suitable technique.

Figure 2 is schematic view depicting the top of the MEMS package 14, the bottom of the MEMS die 10, and the solder pre-form 36 of Figure 1. The solder pre-form 36 and seal rings 32 and 34 are shown as having generally the same shape so they mate with each other to form a seal during processing. They are shown as generally rectangular but may be any desired shape. Bond pads 26 and 28 are configured so that they too will mate during the sealing process, and form electrical connections between the MEMS die 10 and the MEMS package 14.

When a solder is used to form the seal between the MEMS die 10 and the MEMS package 14, the MEMS package 14 may be picked and placed into a bonding chamber, and a solder pre-form 36 may be placed on seal ring 34. The position of the MEMS package 14 may be sensed or verified using photo-registration (e.g. using pattern recognition) or any other suitable technique, as desired. A MEMS die 10 may then be picked and placed, sometimes using a flipper station to first flip the MEMS die 10 so that the MEMS side of the MEMS die 10 faces the MEMS package 14. A tool may be provided to pick up the MEMS die 10 from the back side. The MEMS die 10 may be photo-registered (e.g. using pattern recognition) for placement accuracy, if desired. One illustrative tool may include a pressure plate for applying pressure to the MEMS die 10 opposite the seal ring and/or the bond pads. The pressure plate may surround a vacuum cup by which the MEMS die 10 is picked.

When so provided, heat may be applied, sometimes via the tool, to melt the solder perform and/or prepare the MEMS die 10 and/or MEMS package 14 for bonding. The MEMS die 10 may in some cases be kept at a lower temperature, if desired, or brought to the same temperature as the MEMS package 14.

In some cases, a controlled environment may be created in the bonding chamber. For example, gases may be extracted from the bonding chamber to form a controlled vacuum pressure therein. The controlled vacuum pressure may be, for example, 1 atmosphere, 0.5 atmosphere, less than 100x10⁻⁵ torr, less than 50x10⁻⁵ torr, less than 15x10⁻⁵ torr, or less than 10x10⁻⁵ torr. In some cases, once the gases are extracted from the bonding chamber, one or more inert gasses may be introduced or otherwise backfilled into the chamber. The backfilled inert gas(es) may be at any pressure, but in some cases, may be less than 10x10⁻² torr, less than 50x10⁻³ torr, less than 20x10⁻³ torr, or less than 50x10⁻⁴ torr. For some applications, the backfilled inert gas(es) may be about 18x10⁻³ torr.

The tool may then bring the MEMS die 10 into engagement with the MEMS package 14, and may apply heat and/or pressure to help form the seal between the seal rings and to simultaneously form electrical connections between corresponding bond pads of the MEMS die 10 and the MEMS package 14. The now formed MEMS package may include the MEMS device 11 in the chamber 33, as best seen in Figure 3. The getter 38 may be activated by heat or other means, if desired.

In some cases, the bond pads of the MEMS die 10 and the bond pads of the MEMS package 14 may be secured by thermo-compression bonding. When so provided, the bond pads of the MEMS die 10 and/or the MEMS package 14 may includes bumps formed from a sufficient quantity of bonding material such as gold, silver, lead, tin, aluminum, or the like. In some embodiments, the bonding material is formed of a single material such as either gold or aluminum. In other embodiments, the bonding material is formed of different materials.

A bonding force can then be applied between the MEMS die 10 and the MEMS package 14 which is sufficient to secure the MEMS die 10 to the MEMS package 14. This bonding force can be any useful force such as, for example, at least 25,000 kg force, or 50,000 kg force, or 100,000 kg force per cumulative gram of bonding material used for all bond pads. While the bonding force is applied, the bonding material may be heated sufficient to aid in securing the MEMS die 10 to the MEMS package 14. The heat can be any useful amount sufficient to raise the temperature of the bonding material to a temperature greater than 300, 350, 450, or 500 degrees C, as desired. In some cases, the bond pads may be thermo-compression bonded in accordance with co-pending U.S. Patent Application Serial No. 10/878,845, filed June 28, 2004, and entitled "Methods and Apparatus For Attaching A Die To A Substrate", which is incorporated herein by reference.

Of course, other suitable equipment and techniques may be used to package the MEMS device 10. For example, a hinged chamber may be provided that flips the MEMS die 10 over to the MEMS package 14. Alternatively, or in addition, the entire process may take place in a larger chamber so that multiple MEMS die 10 may be simultaneously bonded to multiple corresponding MEMS packages 14, as desired. It is also contemplated that the operability of the MEMS device may be verified prior to or after the MEMS die and the MEMS package are secured together.

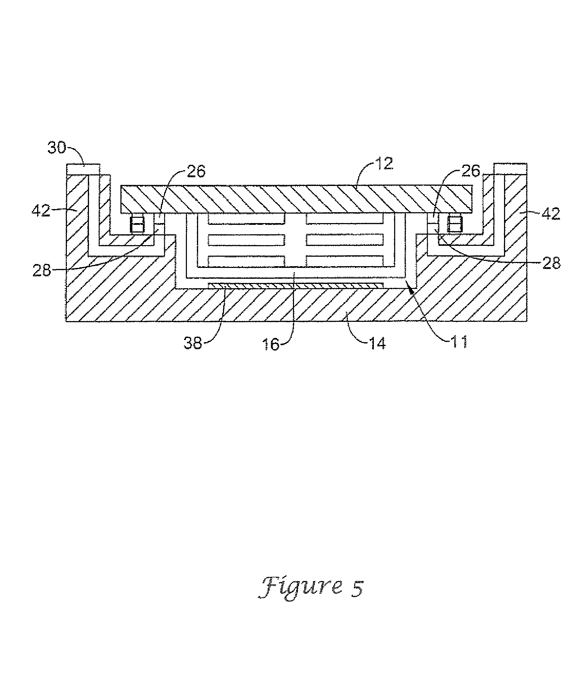

Figure 4 is a schematic cross-sectional side view of another illustrative MEMS die, solder pre-form and MEMS package. This illustrative embodiment is similar to that shown and described above with respect to Figures 1-3, but in this case, the MEMS package 14 includes on its perimeter a riser 42 that extends beyond MEMS die 10 so that leads 30 may more easily be connected to a circuit board or other component. That is, in the illustrative embodiment of Figure 4, the MEMS package 14 may be configured and used as a leadless chip carrier (LCC) package. In the illustrative embodiment, riser 42 extends beyond the back side of substrate 12 of MEMS die 12, but it is contemplated that rise 42 may merely extend far enough to permit leads 30 to bond to an adjacent circuit board. For example, in some cases, riser 42 may extend only far enough for the leads 30 to be flush or nearly flush with the back side of substrate 12 of MEMS die 10. In any event, and as can be seen, the substrate 12 of MEMS die 10 may be somewhat protected when the packaged MEMS device is mounted to a circuit board or the like, because it is situated between the MEMS package 14 and the circuit board or the like (not shown). Figure 5 is a schematic cross-sectional side view of the illustrative MEMS die 10, solder pre-form 36 and MEMS package 14 of Figure 4 after assembly.

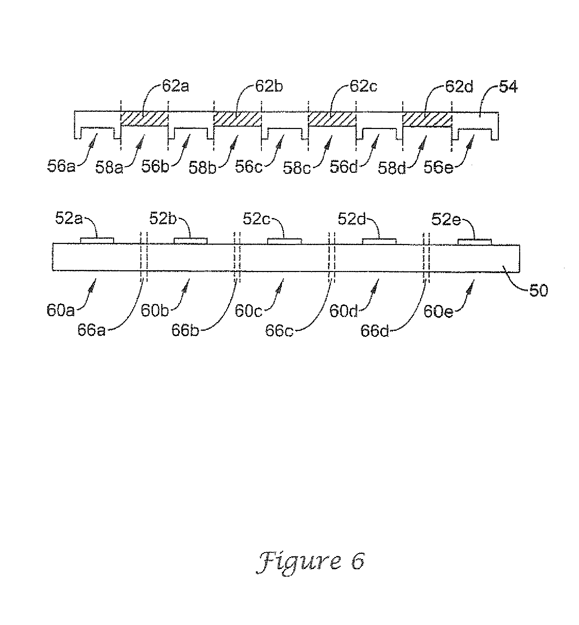

Figure 6 is a schematic cross-sectional side view showing an illustrative method for making a MEMS die having an upper sense plate, such as MEMS die 10. In the illustrative method, a first wafer 50 is provided. The first wafer 50 may be a glass (e.g. Pyrex^{™}) wafer, or may be any other suitable wafer as desired. A MEMS device 52a, such as a MEMS gyroscope, accelerometer or other structure, may be bonded to the first wafer 50. In the illustrative embodiment, a number of MEMS devices 52a-52e are bonded to the first wafer 50; one for each MEMS die 60a-60e.

In some cases, the MEMS devices 52a-52e may include one or more suspended structures positioned vertically above the substrate such as shown in Figure 1. In many cases, MEMS gyroscopes includes two proof masses that are suspended above a substrate, and are driven electrostatically 180° out of phase along a drive plane. A lower sense plate may be provided under each of the proof masses, often directly on the first wafer 50, to detect deflections in the positions of the proof masses caused by rotation or angular displacement of the gyroscope sensor. In some cases, the MEMS devices 52a-52e may be made by micromachining a silicon substrate, the result of which is bonded to the first wafer 50. This, however, is only illustrative, and it is contemplated that the MEMS devices 52a-52e may be made from any number of materials or material systems including, for example, quartz, silicon, gallium arsenide, germanium, glass, and/or any other suitable material.

The illustrative MEMS devices 52a-52e may also include a number of bond pads (see Figure 1). The bond pads may be electrically connected (not illustrated) to the MEMS devices 52a-52e, and in particular to one or more of the sense plates, one or more proof masses, and/or other components or parts of the MEMS devices 52a-52e, as desired. The bond pads may be positioned between a patterned seal ring (see Figure 1) and the MEMS devices 52a-52e, but this is not required. The bond pads may be connected by leads or traces running on, for example, a surface of the first wafer 50, as desired. A patterned seal ring may completely encircle the MEMS devices 52a-52e for each MEMS die 60a-60e, and in some cases, encircle the corresponding bond pads, but this is not required (see Figure 1).

A second wafer 54 may also be provided. The second wafer 54 may be a glass (e.g. Pyrex^{™}) wafer, or may be any other suitable wafer as desired. In the illustrative embodiment, a number of recesses 56a-56e may be etched or otherwise formed in the surface of the second wafer 54. The depth of recesses 56a-56e may be adapted to result in a desired spacing between the back wall of the recesses 56a-56e and the proof masses or other structures of the MEMS devices 52a-52e. A metal or other conductive layer may patterned on or in the recesses 56a-56e to form one or more upper sense plates, if desired. The patterned or other conductive layer may extend up the edge of the recesses 56a-56e and make electrical contact with corresponding pads on the first wafer 50, once the second wafer 54 is bonded to the first wafer, as further described below.

Additional recesses 58a-58d may also be etched or otherwise provided in the second wafer 54. In the illustrative embodiment, the depth of recesses 58a-58d may be set so that a saw blade or the like can cut or otherwise remove regions 62a-62d of the second wafer 54 without engaging or otherwise damaging the first wafer 50, as further described below. In the illustrative embodiment, the depth of recesses 58a-58d may be greater than the depth of recesses 56a-56e.

The second wafer 54 may be flipped and bonded to the first wafer 50 such that the metal or other conductive layer on or in the recesses 56a-56e form one or more upper sense plates for the MEMS devices 52a-52e. The second wafer 54 may be bonded to the first wafer 52 using any suitable method. In one illustrative embodiment, the second wafer 54 is bonded to the first wafer 52 using anodic bonding.

Once the second wafer 54 has been bonded to the first wafer 52, the resulting wafer pair may be diced to provide individual MEMS die 60a-60e. In the illustrative embodiment, a saw blade or the like can cut or otherwise remove regions 62a-62d of the second wafer 54, preferably without engaging or otherwise damaging the first wafer 50. Next, a saw blade or the like can be used to cut or otherwise remove regions 66a-66d of the first wafer 50 to separate the individual MEMS die 60a-60e from each other. [Para 47] Having thus described the several embodiments of the present invention, those of skill in the art will readily appreciate that other embodiments may be made and used which fall within the scope of the claims attached hereto. Numerous advantages of the invention covered by this document have been set forth in the foregoing description. It will be understood that this disclosure is, in many respects, only illustrative. Changes may be made in details, particularly in matters of shape, size and arrangement of parts without exceeding the scope of the invention.

## Claims

1. A MEMS die comprising:
a substrate;
one or more suspended structures positioned vertically above the substrate; the one or more suspended structures located in a first region of the substrate;
the substrate having a second region that extends around the periphery of the first region;
a seal region disposed on the second portion of the substrate, wherein the seal region extends around the first portion; and
a plurality of bond pads disposed in the second portion of the first substrate.

2. The MEMS die of claim 1, wherein at least some of the plurality of bond pads are positioned between the seal region and first region of the substrate.

3. The MEMS die of claim 1, wherein at least some of the plurality of bond pads are positioned outside of the seal region.

4. The MEMS die of claim 1 wherein the one or more suspended structures include a proof mass.

5. The MEMS die of claim 4 wherein the one or more suspended structures include an upper sense plate positioned above and adjacent the proof mass.

6. The MEMS die of claim 5 further comprising a lower sense plate positioned between the proof mass and the substrate.

7. The MEMS die of claim 6 wherein one of the bond pads is electrically connected to the lower sense plate.

8. The MEMS die of claim 6 wherein one of the bond pad is electrically connected to the upper sense plate.

9. The MEMS die of claim 1 further comprising a getter.

10. The MEMS die of claim 1 wherein the seal region includes a metallic seal ring.
